# FASCICULE DE BREVET EUROPEEN

(11) **EP 3 937 244 B1**
(45) Date de publication et mention de la délivrance du brevet: **07.02.2024**
(21) Numéro de dépôt: 21180922.3
(22) Date de dépôt: 22.06.2021
(51) Int. Cl.: H01L 27/146

(54) **PROCÉDÉ DE RÉALISATION D'UN IMAGEUR**
HESTELLUNGSVERFAHREN EINER BILDAUFNAHMEVORRICHTUNG
MANUFACTURING METHOD FOR AN IMAGING DEVICE

(30) Priorité: 09.07.2020 FR 2007307
(43) Date de publication de la demande: 12.01.2022
(73) Titulaire: Trixell, 38430 Moirans (FR)
(72) Inventeur: JANVIER, Yannick, 38430 MOIRANS (FR)
(74) Mandataire: Atout PI Laplace

(56) Documents cités:
- JP-A- 2013 004 715
- US-A1- 2010 255 629
- US-B1- 9 117 721

## Description

L'invention se situe dans le domaine technique de réalisation d'imageurs constitués de capteurs d'imagerie CMOS ou CCD raboutés. Plus particulièrement, l'invention concerne le raboutage de plaques photosensibles pour des capteurs digitaux, par exemple pour l'imagerie médicale sous X en technologie CMOS, abréviation de l'acronyme anglo-saxon Complementary Metal Oxide Semiconductor. Le document US2010/255629A est relevant.

Un capteur photosensible est généralement réalisé à partir d'éléments photosensibles à l'état solide arrangés en matrice. Les éléments photosensibles sont réalisés à partir de matériaux semi-conducteurs, le plus souvent du silicium monocristallin pour les capteurs de type CCD ou CMOS, du silicium polycristallin ou amorphe. Un élément photosensible comporte au moins une photodiode, un phototransistor ou une photorésistance. Ces éléments sont déposés sur un substrat ou intégrés dans ledit substrat, qui est généralement un support (aussi appelé dalle) de verre, de plastique (polymère) ou métallique ou d'un autre matériau de synthèse (carbone, alliage, céramique ...), voire encore de silicium. On obtient alors une plaque photosensible.

Dans le cadre de la réalisation d'imageurs pour l'imagerie médicale sous X, l'opération de raboutage de plaques photosensibles, c'est-à-dire la réunion bout à bout de plaques photosensibles, en technologie CCD ou CMOS implique la tenue de tolérances serrées. Il est en effet important à la fois de limiter des pertes de zones de pixels sur les lignes de raboutage et d'assurer l'alignement des pixels des différents capteurs assemblés. En plus, il est nécessaire d'éviter tout contact entre les plaques pendant l'opération de raboutage des plaques photosensibles sous peine d'un risque de casse, d'ébréchure, et/ou de décharge électrostatique.

Jusqu'à présent, cette opération de raboutage de plaques photosensibles est réalisée avec des moyens industriels complexes, coûteux et présentant des temps de cycles longs afin de garantir les tolérances d'alignement et l'absence de risque de collision entre plaques.

De plus, les moyens industriels complexes de l'art antérieur présentent la limitation d'être dédiés à une dimension de plaque unique. Ils sont basés sur des moyens de préhension des plaques de dimensions prédéfinies et l'alignement est obtenu au moyen de caméras d'alignement selon un espacement associé à la dimension de plaque unique.

Un autre problème des solutions existantes concerne le test de conformité du produit obtenu. En effet, ce test de conformité du produit obtenu après cette opération longue et complexe ne peut se faire qu'à l'issue des opérations de raboutage et de connexion par câblage par fil (aussi connu sous le terme anglo-saxon « wire bonding »). En d'autres termes, si une non-conformité est détectée lors d'un procédé de l'art antérieur, elle ne peut l'être que sur le produit fini. Le produit est mis au rebut. Cela signifie une perte de matières utilisées et une perte de temps.

Autrement dit, les solutions existantes connues pour le raboutage de plaques photosensibles n'offrent pas de solution rapide, peu coûteuse, flexible et facilement testable pendant le procédé de raboutage.

L'invention vise à pallier tout ou partie des problèmes cités plus haut en proposant un procédé de raboutage de plaques photosensibles permettant la réalisation de sous-éléments connectés et testables individuellement, réduisant sensiblement le risque de non-conformité détecté sur produit fini. En outre, le procédé objet de l'invention permet une facilité d'alignement des sous-éléments. Il offre également une grande flexibilité sur les dimensions des capteurs obtenus sans investissements lourds ni de mise au point longue et complexe. D'autres avantages du procédé selon l'invention sont détaillés ci-dessous.

A cet effet, l'invention a pour objet un procédé de réalisation d'un imageur comme décrit dans la revendication 1. D'autres modes de réalisation avantageux sont cités dans les revendications dépendantes 2 à 6.

L'invention concerne aussi un imageur comme décrit dans la revendication 7. La revendication 8 décrit un autre mode de réalisation.

L'invention sera mieux comprise et d'autres avantages apparaîtront à la lecture de la description détaillée d'un mode de réalisation donné à titre d'exemple, description illustrée par le dessin joint dans lequel :
[Fig. 1] La figure 1 représente un diagramme des étapes du procédé de réalisation d'un imageur selon l'invention ;
[Fig.2] La figure 2 représente schématiquement les principales étapes du procédé de réalisation d'un imageur selon l'invention ;
[Fig.3] La figure 3 représente schématiquement un mode de réalisation d'un imageur selon l'invention.

Sur ces figures, dans un souci de clarté, les échelles ne sont pas respectées. Par ailleurs, les mêmes éléments porteront les mêmes repères dans les différentes figures.

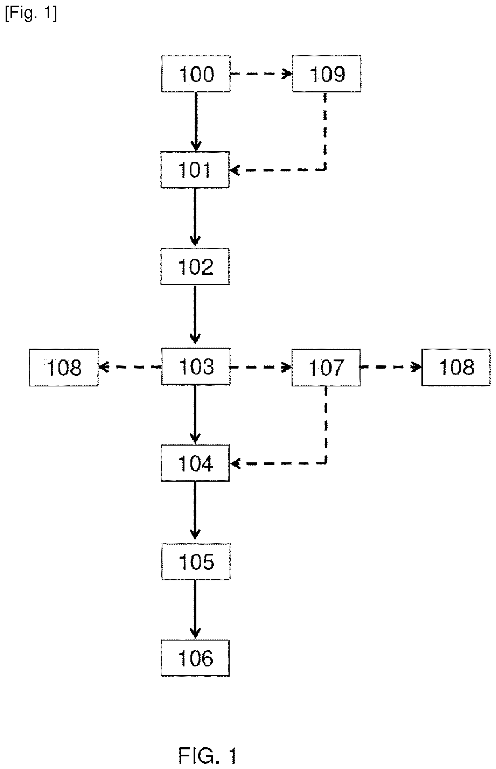

La figure 1 représente un diagramme des étapes du procédé de réalisation d'un imageur selon l'invention. Le procédé de réalisation d'un imageur comprend les étapes 100 à 106 qui seront détaillées ci-dessous. De manière optionnelle, il peut comprendre les étapes 107, 108, 109, prises isolément ou en combinaison.

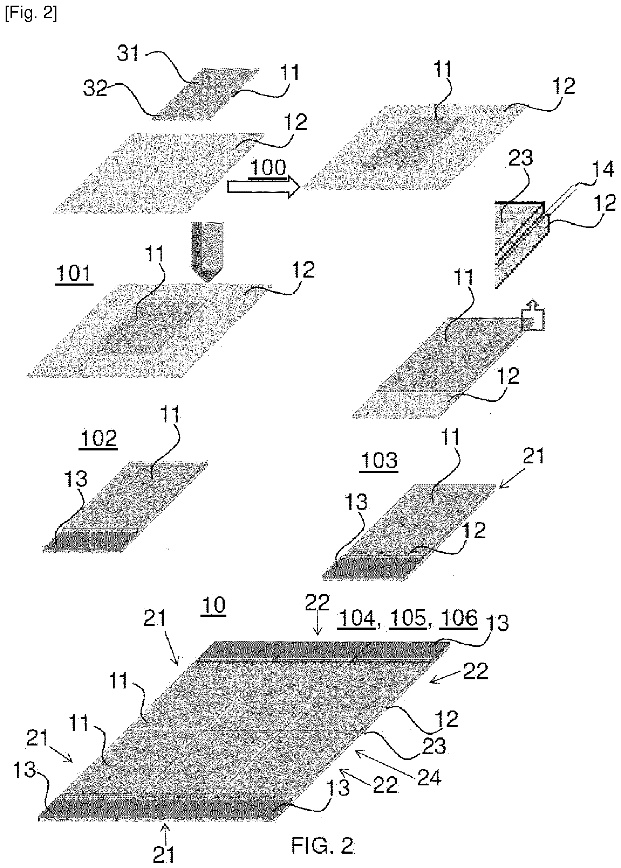

La figure 2 représente schématiquement les principales étapes du procédé de réalisation d'un imageur selon l'invention.

Le procédé de réalisation d'un imageur 10 comprend une première étape 100 de fixation d'un capteur d'imagerie 11 sur un premier substrat 12. Le procédé selon l'invention peut s'appliquer à un capteur d'imagerie 11 de technologie CMOS ou CCD. Le capteur d'imagerie 11 est ici représenté de forme rectangulaire, mais il peut prendre d'autres formes polygonales. Le capteur d'imagerie 11 comprend une zone d'image 31 et une zone de pilotage et connexion 31, destinée à relier le capteur d'imagerie 11 à une carte électronique de pilotage et d'assurer le pilotage du capteur d'imagerie 11. Le premier substrat 12 peut être en verre, en céramique ou en matériau cristallin adapté au support d'un capteur d'imagerie 11. L'étape 100 de fixation du capteur d'imagerie 11 sur le premier substrat 12 est généralement réalisée par collage. Un tel collage est avantageusement obtenu par application d'un film adhésif double-face sur le premier substrat 12. Alternativement, une colle peut être déposée sur le substrat 12. Même si le collage par film adhésif demeure la fixation préférée, d'autres méthodes de fixation du capteur d'imagerie 11 sur le premier substrat 12 peuvent être mises en oeuvre.

Le collage de capteurs d'imagerie 11 individuels sur le premier substrat 12 se fait ainsi sans contraintes serrées d'alignement. L'alignement se fait à quelques millimètres au lieu des quelques microns qui seraient nécessités par un procédé de l'art antérieur.

Le procédé selon l'invention comprend ensuite une deuxième étape 101 de découpe du premier substrat 12 à une distance 14 prédéfinie autour du capteur d'imagerie 11 collé. La découpe se fait tout autour du capteur d'imagerie en laissant un petit rebord le long de la zone d'image 31 et un espace plus important le long d'un bord de la zone de pilotage et de connexion 32 du capteur d'imagerie 11. Ce dernier espace est destiné à recevoir une carte électronique de pilotage du capteur d'imagerie 11. Comme le capteur d'imagerie 11 est collé sur le premier substrat 12, c'est le premier substrat 12 qui est découpé. Cette découpe doit être précise (de l'ordre de 5 micromètres) et peut être réalisée avec des équipements conventionnels, par exemple par découpe au rayon laser ou aux faisceaux de Bessel. Les faisceaux de Bessel sont une forme de faisceaux laser construits par interférences sur une longue distance, permettant une concentration intense de l'énergie pouvant se prolonger sans diffraction à l'intérieur de matériaux transparents. Des faisceaux de Bessel générés avec un laser ultra-bref permettent une ablation en profondeur du matériau exposé, ce qui est particulièrement adapté pour le perçage de nano-canaux de hauts rapports de forme. Il est ainsi possible de percer dans des couches de verre de plusieurs millimètres d'épaisseur des canaux de très faibles diamètres (moins de 2 micromètres). Après le perçage de nano-canaux dans le premier substrat, celui-ci peut se découper le long d'une ligne définie par les nano-canaux. Cette technique permet un bon contrôle de perçage, pour assurer la qualité et précision d'usinage nécessaires à un usinage de précision du verre à échelle industrielle.

L'étape de découpe peut se réaliser en face avant ou en face arrière du premier substrat 12. La découpe par la face arrière demeure la solution privilégiée pour éviter d'éventuelles projections sur le capteur d'imagerie 11. Il est également possible de réaliser l'étape de découpe par lames, mais il faut toutefois s'assurer de la précision de la découpe et veiller à ne pas générer de pollution sur le capteur d'imagerie sous peine de l'endommager.

L'étape de découpe apporte un autre avantage de protection mécanique et électrique (ESD) des sous-ensembles capteur d'imagerie 11 fixé sur le premier substrat 12. En effet, le premier substrat 12 est découpé au-delà des dimensions des capteurs d'imagerie 11 supprimant le risque de contact latéral entre capteurs d'imagerie 11 lors des manipulations ultérieures.

La figure 2 représente un élargissement du premier substrat 12 après l'étape 101 de découpe qui laisse un petit rebord tout autour de la zone d'image 31 du capteur d'imagerie 11, à une distance 14 du capteur d'imagerie 11.

Le procédé selon l'invention comprend en outre une troisième étape 102 de fixation d'une carte électronique de pilotage 13 du capteur d'imagerie 11 sur le premier substrat 12 découpé, à proximité du capteur d'imagerie 11 fixé. Plus précisément, la carte électronique de pilotage 13 est fixée sur le premier substrat 12 de sorte à juxtaposer la zone de pilotage et de connexion 32 du capteur d'imagerie 11. La fixation de la carte électronique de pilotage 13 peut être notamment obtenue par collage, au moyen d'un film adhésif ou avec de la colle.

Ensuite, le procédé selon l'invention comprend une quatrième étape 103 de connexion de la carte électronique de pilotage 13 du capteur d'imagerie 11 avec le capteur d'imagerie 11 fixé pour obtenir une première tuile 21. La carte électronique de pilotage 13 est connectée à la zone de pilotage et de connexion 32 du capteur d'imagerie 11. L'étape 103 de connexion peut être réalisée par câblage par fils (aussi connu sous la dénomination anglo-saxonne wire bounding). Le câblage par fil ou pontage est une des techniques utilisées pour effectuer les connexions électriques entre le capteur d'imagerie 11 et la carte électronique de pilotage 13. Le câblage est réalisé par un fil (ou pont) soudé entre les deux plots de connexion prévus à cet usage sur chacun des éléments à connecter. La soudure est généralement réalisée par ultrasons. Le matériau du fil est de l'aluminium, de l'or ou du cuivre. Le diamètre du fil est de l'ordre de 20 µm. Les étapes 100 à 103 sont réalisées successivement pour une tuile. Plusieurs étapes 100 à 103 peuvent être réalisées en parallèle, c'est-à-dire en même temps, pour obtenir plusieurs tuiles.

Pour obtenir une deuxième tuile 22, les première, deuxième, troisième et quatrième étapes sont répétées. Nous disposons alors de deux tuiles 21, 22, chacune sur son premier substrat 12. Autrement dit, il y a autant de premiers substrats 12 qu'il y a de tuiles. Le procédé est ici expliqué avec deux tuiles, mais le principe s'applique de façon identique à un nombre quelconque de tuiles. Nous en voyons six sur l'imageur de la figure 2, et le procédé trouve une application particulièrement intéressante pour un imageur de très grande dimension mettant en oeuvre un plus grand nombre de tuiles.

Le procédé selon l'invention comprend une cinquième étape 104 de raboutage de la première tuile 21 et la deuxième tuile 22 obtenues par mise en contact bord à bord des deux premiers substrats 12 découpés. Le raboutage est l'action de rabouter, c'est-à-dire assembler, réunir bout à bout. La tuile 21 est juxtaposée à la tuile 22. Autrement dit, le premier substrat 11, après l'étape 101 de découpe, laisse apparaître une surface latérale sensiblement perpendiculaire au plan du capteur d'imagerie 11. Chaque tuile dispose donc de trois surfaces latérales libres, autour de la zone d'image 31. Deux tuiles sont raboutées par mise en contact d'une surface latérale libre d'une tuile avec une surface latérale d'une autre tuile. Par raboutage des tuiles deux-à-deux, il est possible d'obtenir une très grande surface de capteurs d'imagerie 11.

Une fois les tuiles raboutées, la position de chacun d'elle est figée. Le procédé comprend alors une sixième étape 105 de fixation des tuiles 21, 22 raboutées sur un substrat principal 23. Le substrat principal 23 vient en face arrière des tuiles, ce qui permet de contribuer à la rigidité de l'imageur.

Enfin, le procédé selon l'invention comprend une septième étape 106 de connexion des cartes électroniques de pilotage 13 des capteurs d'imagerie 11 de la première tuile 21 et de la deuxième tuile 22 raboutées à une carte mère 24 de l'imageur 10. Les étapes 104 à 106 sont réalisées successivement. Elles peuvent être réalisées en parallèle, c'est-à-dire en même temps pour plusieurs groupes de tuiles.

Dans un mode de réalisation de l'invention, le procédé de réalisation d'un imageur peut comprendre, après la quatrième étape 103 de connexion de la carte électronique de pilotage 13 du capteur d'imagerie 11 avec le capteur d'imagerie 11 fixé, une étape 107 de test de conformité de la tuile.

La découpe des capteurs d'imagerie 11 réalisée individuellement sur le premier substrat 12 et leur connexion à leur carte électronique de pilotage 13 permettent d'isoler chaque tuile. Chaque tuile peut donc être testée et caractérisée individuellement avant stockage, appairage et assemblage des tuiles pour réalisation de l'imageur final.

Le test de conformité des tuiles individuelles évite les risques de rebut de sous-ensembles à forte valeur ajoutée car le test de conformité intervient très tôt dans le procédé de réalisation de l'imageur et permet d'écarter une tuile qui serait défectueuse.

Dans un mode de réalisation de l'invention, le procédé de réalisation d'un imageur peut comprendre, après la quatrième étape 103 de connexion de la carte électronique de pilotage 13 du capteur d'imagerie 11 avec le capteur d'imagerie 11 collé, une étape 108 de stockage de la tuile.

Entre outre, la réalisation de tuile individuelle répond à un besoin de stockage sécurisé. Chaque capteur d'imagerie 11 étant collé sur son premier substrat 12, il n'y a peu ou pas de risque de casse. Il est également possible d'effectuer la traçabilité à réception des capteurs d'imagerie sur film de découpe avant la date de limite d'utilisation du traitement UV. En effet, grâce au procédé de réalisation selon l'invention, la fabrication d'un imageur peut être réalisée en deux temps : les étapes 100 à 103 sont réalisées pour obtenir une tuile individuelle, puis la tuile est stockée. Dans un second temps, on peut rabouter une pluralité de tuiles stockées et récemment réalisées.

Dans un mode de réalisation de l'invention, le procédé de réalisation d'un imageur peut comprendre, après la première étape 100 de fixation, une étape 109 de marquage du premier substrat 12. Le marquage peut être réalisée par une étiquette, l'apposition d'un code barre, ou par gravure d'un numéro ou d'un code permettant la traçabilité du capteur d'imagerie 11. Une fois collé sur le premier substrat 12, le premier substrat 12 peut être aisément gravé pour assurer le lien avec les données de fabrication de la puce (numéro de lot, caractéristiques de l'image,...).

Enfin, on peut noter que la première tuile 21 peut avoir des dimensions différentes des dimensions de la deuxième tuile 22. Cette possibilité de rabouter des tuiles de dimensions différentes apporte une grande flexibilité dans le type d'imageur que l'on peut réaliser grâce au procédé selon l'invention.

L'invention propose une solution qui utilise de manière nouvelle et inventive des équipements et procédés standard pour permettre la réalisation d'imageurs de grandes dimensions. L'invention évite les risques de rebut à forte valeur ajoutée liés à un désalignement lors d'un raboutage classique (collage de l'ensemble des puces sur un substrat unique), une casse du capteur d'imagerie lors de l'opération de raboutage d'un ensemble de capteurs d'imagerie sur un substrat unique, un endommagement de capteurs d'imagerie par choc électrostatique, uniquement détectable aux tests après assemblage de l'ensemble des capteurs d'imagerie.

L'invention propose une solution permettant une découpe rapide des sous-ensembles « capteur d'imagerie collé sur le premier substrat », de l'ordre de 200 à 300 mm/s, ce qui signifie des temps de cycle courts. Grâce à l'élaboration de tuiles individuelles, l'invention permet un stockage sécurisé des tuiles testées et fonctionnelles.

Chaque capteur d'imagerie étant collé sur une potion de premier substrat, l'invention assure une bonne traçabilité du capteur d'imagerie sur le premier substrat de la tuile.

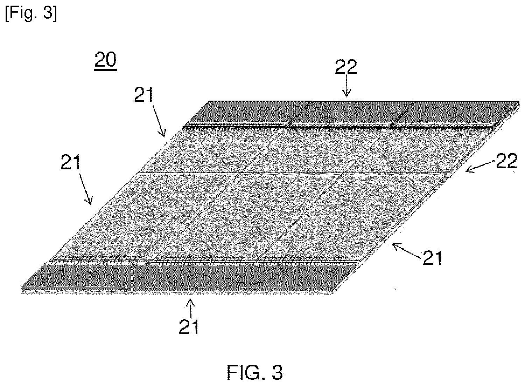

La figure 3 représente schématiquement un mode de réalisation d'un imageur selon l'invention. L'imageur 20 comprend une première tuile 21 et une deuxième tuile 22, chacune des tuiles 21, 22 comprend un premier substrat 12, un capteur d'imagerie 11 fixé sur le premier substrat 12, le premier substrat 12 étant découpé à une distance 14 prédéfinie autour du capteur d'imagerie 11 collé, une carte électronique de pilotage 13 du capteur d'imagerie 11 fixé sur le premier substrat 12 à proximité du capteur d'imagerie 11 et connectée au capteur d'imagerie 11. Selon l'invention, la première tuile 21 et la deuxième tuile 22 sont raboutées par mise en contact bord à bord des deux premiers substrats 12. L'imageur 20 comprend en outre un substrat principal 23 sur lequel les tuiles raboutées sont fixées, et une carte mère 24 connectée aux cartes électroniques de pilotage 13 des capteurs d'imagerie 11 de la première tuile 21 et la deuxième tuile 22 raboutées, pour piloter la pluralité de cartes électroniques de pilotage 13 des capteurs d'imagerie 11. L'imageur 20 comprend ainsi une pluralité de tuiles et une pluralité de premiers substrats 12 (chaque tuile ayant son propre premier substrat). Et les tuiles sont raboutées par mise en contact bord à bord des premiers substrats individuels des tuiles. Les tuiles ainsi raboutées sont fixées sur un substrat principal 23, distinct des premiers substrats.

Dans l'imageur 20 représenté sur la figure 3, la première tuile 21 a des dimensions différentes des dimensions de la deuxième tuile 22. Mais l'invention concerne aussi un imageur 10 dans lequel toutes les tuiles ont les mêmes dimensions.

L'invention s'applique à tout capteur d'images réalisé par raboutage de dalles photosensibles CMOS ou autre technologie.

## Revendications

1. Procédé de réalisation d'un imageur (10, 20), comprenant les étapes suivantes :
a. Une première étape (100) de fixation d'un capteur d'imagerie (11) sur un premier substrat (12);
b. Une deuxième étape (101) de découpe du premier substrat (12) à une distance prédéfinie autour du capteur d'imagerie (11) fixé ;
c. Une troisième étape (102) de fixation d'une carte électronique de pilotage (13) du capteur d'imagerie (11) sur le premier substrat (12) découpé, à proximité du capteur d'imagerie (11) fixé ;
d. Une quatrième étape (103) de connexion de la carte électronique de pilotage (13) du capteur d'imagerie (11) avec le capteur d'imagerie (11) fixé pour obtenir une première tuile (21) associée audit premier substrat de la première tuile ;
e. Répéter les première, deuxième, troisième et quatrième étapes pour obtenir une deuxième tuile (22) associée audit premier substrat (12) de la deuxième tuile ;
f. Une cinquième étape (104) de raboutage de la première tuile (21) et la deuxième tuile (22) obtenues par mise en contact bord à bord des deux premiers substrats (12) découpés ;
g. Une sixième étape (105) de fixation des tuiles (21, 22) raboutées sur un substrat principal (23) ;
h. Une septième étape (106) de connexion des cartes électroniques de pilotage (13) des capteurs d'imagerie (11) de la première tuile (21) et de la deuxième tuile (22) raboutées à une carte mère (24) de l'imageur (10, 20).

2. Procédé de réalisation d'un imageur (10, 20) selon la revendication 1, comprenant, après la quatrième étape (103) de connexion de la carte électronique de pilotage (13) du capteur d'imagerie (11) avec le capteur d'imagerie (11) collé, une étape (107) de test de conformité de la tuile (21, 22).

3. Procédé de réalisation d'un imageur (10, 20) selon l'une quelconque des revendications 1 ou 2, comprenant, après la quatrième étape (103) de connexion de la carte électronique de pilotage (13) du capteur d'imagerie (11) avec le capteur d'imagerie (11) collé, une étape (108) de stockage de la tuile (21, 22).

4. Procédé de réalisation d'un imageur (10, 20) selon l'une quelconque des revendications 1 à 3, **caractérisé en ce que** la deuxième étape (101) de découpe du premier substrat (12) est une étape de découpe au rayon laser ou aux faisceaux de Bessel.

5. Procédé de réalisation d'un imageur (10, 20) selon l'une quelconque des revendications 1 à 4, comprenant, après la première étape (100) de fixation, une étape (109) de marquage du premier substrat (12).

6. Procédé de réalisation d'un imageur (20) selon l'une quelconque des revendications 1 à 5, dans lequel la première tuile (21) a des dimensions différentes des dimensions de la deuxième tuile (22).

7. Imageur (10, 20) comprenant une première tuile (21) et une deuxième tuile (22), chacune des tuiles (21, 22) comprenant :
a. un premier substrat (12),
b. un capteur d'imagerie (11) fixé sur le premier substrat (12), le premier substrat (12) étant découpé à une distance (14) prédéfinie autour du capteur d'imagerie (11) collé,
c. une carte électronique de pilotage (13) du capteur d'imagerie (11) fixé sur le premier substrat (12) à proximité du capteur d'imagerie (11) et connectée au capteur d'imagerie (11),
la première tuile (21) et la deuxième tuile (22) étant raboutées par mise en contact bord à bord des deux premiers substrats (12), chacun des deux premiers substrats étant associé à une parmi la première tuile et la deuxième tuile,
ledit imageur (10, 20) comprenant en outre un substrat principal (23) sur lequel les tuiles raboutées sont fixées, et une carte mère (24) connectée aux cartes électroniques de pilotage (13) des capteurs d'imagerie (11) de la première tuile (21) et la deuxième tuile (22) raboutées.

8. Imageur (20) selon la revendication 7, dans lequel la première tuile (21) a des dimensions différentes des dimensions de la deuxième tuile (22).

## Patentansprüche

1. Verfahren zur Herstellung eines Bildgebers (10, 20), das die folgenden Schritte umfasst:
a. einen ersten Schritt (100) des Fixierens eines Bildgebungssensors (11) auf einem ersten Substrat (12);
b. einen zweiten Schritt (101) des Ausschneidens des ersten Substrats (12) in einem vordefinierten Abstand um den fixierten Bildgebungssensor (11) herum;
c. einen dritten Schritt (102) des Fixierens einer Treiberplatine (13) des Bildgebungssensors (11) auf dem ausgeschnittenen ersten Substrat (12) in der Nähe des fixierten Bildgebungssensors (11);
d. einen vierten Schritt (103) des Verbindens der Treiberplatine (13) des Bildgebungssensors (11) mit dem fixierten Bildgebungssensor (11), um eine dem ersten Substrat der ersten Kachel zugeordnete erste Kachel (21) zu erhalten;
e. Wiederholen des ersten, zweiten, dritten und vierten Schritts, um eine dem ersten Substrat (12) der zweiten Kachel zugeordnete zweite Kachel (22) zu erhalten;
f. einen fünften Schritt (104) des Aneinanderfügens der erhaltenen ersten Kachel (21) und zweiten Kachel (22) durch Inkontaktbringen der beiden ausgeschnittenen ersten Substrate (12) Rand an Rand;
g. einen sechsten Schritt (105) des Fixierens der aneinandergefügten Kacheln (21, 22) auf einem Hauptsubstrat (23);
h. einen siebten Schritt (106) des Verbindens der Treiberplatinen (13) der Bildgebungssensoren (11) der aneinandergefügten ersten Kachel (21) und zweiten Kachel (22) mit einer Hauptplatine (24) des Bildgebers (10, 20).

2. Verfahren zur Herstellung eines Bildgebers (10, 20) nach Anspruch 1, das nach dem vierten Schritt (103) des Verbindens der Treiberplatine (13) des Bildgebungssensors (11) mit dem geklebten Bildgebungssensor (11) einen Schritt (107) des Prüfens der Konformität der Kachel (21, 22) umfasst.

3. Verfahren zur Herstellung eines Bildgebers (10, 20) nach Anspruch 1 oder 2, das nach dem vierten Schritt (103) des Verbindens der Treiberplatine (13) des Bildgebungssensors (11) mit dem geklebten Bildgebungssensor (11) einen Schritt (108) des Lagerns der Kachel (21, 22) umfasst.

4. Verfahren zur Herstellung eines Bildgebers (10, 20) nach einem der Ansprüche 1 bis 3, **dadurch gekennzeichnet, dass** der zweite Schritt (101) des Ausschneidens des ersten Substrats (12) ein Schritt des Schneidens mit Laser- oder Besselstrahlen ist.

5. Verfahren zur Herstellung eines Bildgebers (10, 20) nach einem der Ansprüche 1 bis 4, das nach dem ersten Schritt (100) des Fixierens einen Schritt (109) des Markierens des ersten Substrats (12) umfasst.

6. Verfahren zur Herstellung eines Bildgebers (20) nach einem der Ansprüche 1 bis 5, wobei die erste Kachel (21) andere Abmessungen als die Abmessungen der zweiten Kachel (22) aufweist.

7. Bildgeber (10, 20), der eine erste Kachel (21) und eine zweite Kachel (22) umfasst, wobei jede der Kacheln (21, 22) Folgendes umfasst:
a. ein erstes Substrat (12),
b. einen am ersten Substrat (12) fixierten Bildgebungssensor (11), wobei das erste Substrat (12) in einem vordefinierten Abstand (14) um den geklebten Bildgebungssensor (11) herum ausgeschnitten ist,
c. eine Treiberplatine (13) des Bildgebungssensors (11), die auf dem ersten Substrat (12) in der Nähe des Bildgebungssensors (11) fixiert und mit dem Bildgebungssensor (11) verbunden ist,
wobei die erste Kachel (21) und die zweite Kachel (22) durch Inkontaktbringen der beiden ersten Substrate (12) Rand an Rand aneinandergefügt werden, wobei jedes der beiden ersten Substrate einer von der ersten Kachel und der zweiten Kachel zugeordnet ist,
wobei der Bildgeber ferner ein Hauptsubstrat (23), , auf dem die aneinandergefügten Kacheln fixiert sind, und eine Hauptplatine (24) umfasst, die mit den Treiberplatinen (13) der Bildgebungssensoren (11) der angefügten ersten Kachel (21) und der angefügten zweiten Kachel (22) verbunden ist.

8. Bildgeber (20) nach Anspruch 7, wobei die erste Kachel (21) andere Abmessungen als die Abmessungen der zweiten Kachel (22) aufweist.

## Claims

1. A method for producing an imager (10, 20), comprising the following steps:
a. a first step (100) of attaching an imaging sensor (11) to a first substrate (12);
b. a second step (101) of cutting out the first substrate (12) at a predefined distance around the attached imaging sensor (11);
c. a third step (102) of attaching a driver circuit board (13) of the imaging sensor (11) to the cut-out first substrate (12), close to the attached imaging sensor (11);
d. a fourth step (103) of connecting the driver circuit board (13) of the imaging sensor (11) to the attached imaging sensor (11) in order to obtain a first tile (21) associated with said first substrate of the first tile;
e. repeating the first, second, third and fourth steps in order to obtain a second tile (22) associated with said first substrate (12) of the second tile;
f. a fifth step (104) of butting together the obtained first tile (21) and second tile (22) by placing the two cut-out first substrates (12) in edge-to-edge contact;
g. a sixth step (105) of attaching the butted-together tiles (21, 22) to a main substrate (23);
h. a seventh step (106) of connecting the driver circuit boards (13) of the imaging sensors (11) of the butted-together first tile (21) and second tile (22) to a motherboard (24) of the imager (10, 20).

2. The method for producing an imager (10, 20) according to claim 1, comprising, after the fourth step (103) of connecting the driver circuit board (13) of the imaging sensor (11) to the bonded imaging sensor (11), a step (107) of testing the conformity of the tile (21, 22).

3. The method for producing an imager (10, 20) according to any one of claims 1 or 2, comprising, after the fourth step (103) of connecting the driver circuit board (13) of the imaging sensor (11) to the bonded imaging sensor (11), a step (108) of storing the tile (21, 22).

4. The method for producing an imager (10, 20) according to any one of claims 1 to 3, **characterised in that** the second step (101) of cutting out the first substrate (12) is a step of cutting by means of laser beam or of Bessel beams.

5. The method for producing an imager (10, 20) according to any one of claims 1 to 4, comprising, after the first attaching step (100), a step (109) of marking the first substrate (12).

6. The method for producing an imager (20) according to any one of claims 1 to 5, wherein the first tile (21) has dimensions that differ from the dimensions of the second tile (22).

7. An imager (10, 20), comprising a first tile (21) and a second tile (22), each of the tiles (21, 22) comprising:
a. a first substrate (12),
b. an imaging sensor (11) attached to the first substrate (12), the first substrate (12) being cut out at a predefined distance (14) around the bonded imaging sensor (11),
c. a driver circuit board (13) of the imaging sensor (11) attached to the first substrate (12) close to the imaging sensor (11) and connected to the imaging sensor (11),
the first tile (21) and the second tile (22) being butted together by placing the two first substrates (12) in edge-to-edge contact, each of the first two substrates being associated with one of the first tile and the second tile,
said imager (10, 20) further comprising a main substrate (23) to which the butted-together tiles are attached, and a motherboard (24) connected to the driver circuit boards (13) of the imaging sensors (11) of the butted-together first tile (21) and second tile (22).

8. Thee imager (20) according to claim 7, wherein the first tile (21) has dimensions that differ from the dimensions of the second tile (22).
